# EUROPEAN PATENT APPLICATION

(11) **EP 4 818 360 A1**
(43) Date of publication of application: **07.10.2026**
(21) Application number: 24891102.6
(22) Date of filing: 27.09.2024
(51) Int. Cl.: C23C 16/36, C23C 16/42, C23C 16/455, H01L 21/314, H01L 21/318

(54) **METHOD FOR DEPOSITING SILICON-CONTAINING FILM**

(30) Priority: 13.11.2023 JP 2023192797
(71) Applicant: L'Air Liquide, Société Anonyme pour l'Etude et l'Exploitation des Procédés Georges Claude, 75007 Paris (FR)
(72) Inventor: NESTEROV, Vitaly, Yokosuka-shi Kanagawa 239-0847 (JP); GIRARD, Jean-Marc, 75007 Paris (FR)
(74) Representative: Air Liquide
(86) International application number: PCT/JP2024/034764
(87) International publication number: WO 2025/105060

(57) **Abstract**

[Problem]

To provide a method for effectively forming a silicon-containing film on a substrate; a substrate on which a silicon-containing film has been formed by said method; and a product comprising the substrate.

[Solution]

compounds represented by formula (1):

R¹₃E-N=C=N-ER¹₃

[in formula (1), E are independently Si, Ge, or Sn, and R' are independently a linear or cyclic C1-C6 alkyl, C2-C6 alkenyl, or C1-C6 alkynyl]
is used, for example.

## Description

### [Technical Field]

The present disclosure relates to a method for forming a silicon-containing film on a substrate. The present disclosure also relates to a substrate on which a silicon-containing film is formed, as well as to a product comprising such a substrate.

### [Background Art]

Silicon nitride-containing films (such as silicon carbonitride (SiCN) films) are widely used as dielectric materials in a variety of applications in the production of semiconductor devices. Development of novel film deposition methods providing superior film properties and process performance is essential in device downscaling and development of novel technologies.

Non-Patent Document 1 states that silicon-containing films have better physical and chemical properties in terms of dielectric properties, engineering/mechanical properties, thermal stability, and oxidation resistance, for example. Non-Patent Document 1 describes a method for depositing a silicon nitride film using continuous pulses of a halosilane compound, an aminosilane compound, and an optional R₂NH compound (R is H, a C1-C4 alkyl, or a combination thereof).

### [Prior Art Literature]

### [Non-Patent Documents]

[Non-Patent Document 1] E. Ermakova, et al., J. Organomet. Chem., Vol. 958, 122183 (2022)

### [Patent Documents]

[Patent Document 1] US Patent Publication 2023/0279545

### [Summary of the Invention]

The present disclosure provides a method for forming a silicon-containing film that allows a silicon-containing film having better properties to be efficiently formed on a substrate. The present disclosure also provides a substrate on which a silicon-containing film having better properties is formed, as well as a product comprising such a substrate.

The following methods are examples of the method for forming a silicon-containing film according to the present disclosure.

A method for forming a silicon-containing film on a substrate, comprising:
(i) providing at least one silicon source compound containing at least one silicon halide onto a substrate; and
(ii) providing a carbon-nitrogen source compound represented by the following formula (1) onto the substrate:

   R¹₃E-N=C=N-ER¹₃

   [in formula (1), E are independently Si, Ge, or Sn, and R¹ are independently a C1-C6 alkyl, C2-C6 alkenyl, C4-C6 cycloalkyl, or C4-C6 cycloalkenyl] .

### [Brief Description of the Drawings]

[Figure 1] Figure 1 shows an example of a scheme for implementing a CVD method in the present disclosure.
[Figure 2] Figure 2 shows the results of analysis by X-ray photoelectron spectroscopy (XPS) of the constituent components of the silicon-containing film of Example 1.

### [Modes for Implementing the Invention]

Embodiments of the present disclosure are described in detail below, but the scope of the present invention is not limited to the embodiments described here, and various changes can be made without departing from the spirit of the present invention. Embodiments may be implemented individually or in combinations of more than one. Particular descriptions of one embodiment that are applicable to other embodiments will not be repeated for such other embodiments.

The numerical ranges in the present disclosure include the upper and lower limits, respectively, that are indicated with "~" and "from." For example, the statement "A~B" or "A to B" using numerical values A and B means A or more to B or less. The expressions "A~B", "A to B", or "A or more to B or less" that are used to indicate the stepwise numerical ranges in the present disclosure also independently include both "preferably A or more" and "preferably B or less," where the lower and upper limits may be replaced with other numerical range upper and lower limits. The lower or upper limits of the numerical ranges given in the present disclosure are numerical values within the numerical range, and may be replaced with the numerical values given in the examples.

The singular forms "a," "an," and "the" used in the present disclosure may include more than one referent, unless otherwise clearly specified. As used in the present disclosure, "and/or" includes both relationships expressed by "and" and relationships expressed by "or." In the present disclosure, "comprises" encompasses "consists primarily of," "consists substantially of," and "consists of," while "consists primarily of" encompasses "consists substantially of" and "consists of,"and "consists substantially of" encompasses "consists of."

### [Method for forming silicon-containing film]

One embodiment provides:
A method for forming a silicon-containing film on a substrate, comprising:
(i) providing at least one silicon source compound containing at least one silicon halide onto a substrate; and
(ii) providing a carbon-nitrogen source compound represented by the following formula (1) onto the substrate:

   R¹₃E-N=C=N-ER¹₃

   [in formula (1), E are independently Si, Ge, or Sn, and R¹ are independently a C1-C6 alkyl, C2-C6 alkenyl, C4-C6 cycloalkyl, or C4-C6 cycloalkenyl] .

In this embodiment, at least one silicon source compound containing at least one silicon halide reacts with a carbon nitrogen source compound represented by formula (1), resulting in the formation of a silicon-containing film comprising silicon, carbon, and nitrogen. The reaction by-products are generally not salts and are highly volatile. The reaction by-products can thus easily be removed from the reaction system.

In order to produce similar silicon-containing films in conventional methods , for example, ethylene, methane, and acetylene are used as a separate carbon source compounds, while ammonia, hydrazine, and amines, for example, are used as a nitrogen source compound directly reacting with the silicon source compound. In these cases, salts (such as ammonium halide) occur as by-products of the reaction between the silicon source compound and the nitrogen source compound. The salts generally have low volatility and are not easy to remove from the reaction system.

Specifically, the method of this embodiment allows the amount of by-products contaminating the silicon-containing film to be reduced. Potential salt contamination of the silicon-containing film can also be reduced or eliminated. The method of this embodiment thus allows a more homogeneous silicon-containing film of higher purity to be formed on the substrate. Potential structural and functional substrate damage as a result of by-product adhesion on the substrate can also be mitigated.

In this embodiment, a single compound can be used as the carbon-nitrogen source compound, thus eliminating the need to separately prepare and use a carbon source compound and a nitrogen source compound, unlike in conventional methods. The method of this embodiment thus allows a silicon-containing film to be formed on a substrate more efficiently with reduced amount of chemicals and steps compared to conventional methods.

This embodiment can also reduce or eliminate the potential formation of C-H, N-H, and E-H bonds in the silicon-containing film (which can adversely affect the sensitivity of the silicon-containing film to humidity, wet etching, and ashing), thereby improving characteristics of the film.

In this embodiment, the silicon-containing film is any film that contains silicon nitride. The silicon-containing film may be, for example, a silicon carbonitride (SiCN) film, a silicon oxycarbonitride (SiOCN) film, a silicoboron carbonitride (SiBCN) film, a silicoboron oxycarbonitride (SiBOCN) film, a silicon carbide (SiC) film, or a mixture thereof.

In this embodiment, E in formula (1) is preferably Si, and R¹ is preferably a C1-C6 alkyl, and more preferably CH₃.

The following are non-limiting examples of compounds of formula (1): (H₃C)₃SiN=C=N-Si(CH₃)₃, (H₅C₂)₃Si-N=C=N-Si(C₂H₅)₃, (H₃C₂)₃Si-N=C=N-Si(C₂H₃)₃, (H₇C₃)₃SiN=C=N-Si(C₃H₇)₃, (H₅C₃)₃Si-N=C=N-Si(C₃H₅)₃, (H₃C₃)₃Si-N=C=N-Si(C₃H₃)₃, (H₉C₄)₃SiN=C=N-Si(C₄H₉)₃, (H₇C₄)₃Si-N=C=N-Si(C₄H₇)₃, (H₅C₄)₃Si-N=C=N-Si(C₄H₅)₃, (H₁₁C₅)₃SiN=C=N-Si(C₅H₁₁)₃, (H₉C₅)₃Si-N=C=N-Si(C₅H₉)₃, (H₇C₅)₃Si-N=C=N-Si(C₅H₇)₃, (H₁₃C₆)₃Si-N=C=N-Si(C₆H₁₃)₃, (H₁₁C₆)₃Si-N=C=N-Si(C₆H₁₁)₃, (H₉C₆)₃Si-N=C=N-Si(C₆H₉)₃, (H₅C₆)₃Si-N=C=N-Si(C₆H₅)₃, (H₃C)₃Ge-N=C=N-Ge(CH₃)₃, (H₅C₂)₃Ge-N=C=N-Ge(C₂H₅)₃, (H₃C₂)₃Ge-N=C=N-Ge(C₂H₃)₃, (H₇C₃)₃Ge-N=C=N-Ge(C₃H₇)₃, (H₅C₃)₃Ge-N=C=N-Ge(C₃H₅)₃, (H₃C₃)₃Ge-N=C=N-Ge(C₃H₃)₃, (H₉C₄)₃Ge-N=C=N-Ge(C₄H₉)₃, (H₇C₄)₃Ge-N=C=N-Ge(C₄H₇)₃, (H₅C₄)₃Ge-N=C=N-Ge(C₄H₅)₃, (H₁₁C₅)₃Ge-N=C=N-Ge(C₅H₁₁)₃, (H₉C₅)₃Ge-N=C=N-Ge(C₅H₉)₃, (H₇C₅)₃Ge-N=C=N-Ge(C₅H₇)₃, (H₁₃C₆)₃Ge-N=C=N-Ge(C₆H₁₃)₃, (H₁₁C₆)₃GeN=C=N-Ge(C₆H₁₁)₃, (H₉C₆)₃Ge-N=C=N-Ge(C₆H₉)₃, (H₅C₆)₃Ge-N=C=N-Ge(C₆H₅)₃, (H₃C)₃Sn-N=C=N-Sn(CH₃)₃, (H₅C₂)₃Sn-N=C=N-Sn(C₂H₅)₃, (H₃C₂)₃Sn-N=C=N-Sn(C₂H₃)₃, (H₇C₃)₃Sn-N=C=N-Sn(C₃H₇)₃, (H₅C₃)₃Sn-N=C=N-Sn(C₃H₅)₃, (H₃C₃)₃Sn-N=C=N-Sn(C₃H₃)₃, (H₉C₄)₃Sn-N=C=N-Sn(C₄H₉)₃, (H₇C₄)₃Sn-N=C=N-Sn(C₄H₇)₃, (H₅C₄)₃Sn-N=C=N-Sn(C₄H₅)₃, (H₁₁C₅)₃Sn-N=C=N-Sn(C₅H₁₁)₃, (H₉C₅)₃Sn-N=C=N-Sn(C₅H₉)₃, (H₇C₅)₃Sn-N=C=N-Sn(C₅H₇)₃, (H₁₃C₆)₃Sn-N=C=N-Sn(C₆H₁₃)₃, (H₁₁C₆)₃Sn-N=C=N-Sn(C₆H₁₁)₃, (H₉C₆)₃Sn-N=C=N-Sn(C₆H₉)₃, and (H₅C₆)₃Sn-N=C=N-Sn(C₆H₅)₃. The compounds of formula (1) may be used alone or in combinations of two or more.

In this embodiment, the silicon source compound may be any compound containing at least one silicon halide, although halosilanes and carbo(halo)silanes, halosiloxanes, organo(halo)siloxanes, and oligohalosilanes are preferably used.

Halosilanes or carbo(halo)silanes allow a film that contains silicon carbonitride (SiCN) to be formed on a substrate.

The following are non-limiting examples of halosilanes or carbo(halo)silanes.
<1> Compounds represented by formula (2):

   SiXₐR₄₋ₐ

   [in formula (2), a is an integer from 2 to 4; X is Cl, Br, or I; R are independently H, a C1-C10 alkyl, a C2-C10 alkenyl, a C2- C10 alkynyl, or a C6-C9 allyl], and preferably SiH₂I₂, SiI₄, SiBr₄, or SiH₃Cl.
<2> Compounds represented by formula (3):

   [R¹X₂Si]₂[CR²R³]ₙ (III)

   [in formula (3), R¹ may independently be Cl, H, a C1-C10 alkyl, or a C2-C10 alkenyl; R² and R³ are independently H, a C1-C3 alkyl, or a C2-C3 alkenyl; n is an integer from 1 to 4; and X is Cl, Br, or I],
   preferably (Cl₃Si)₂CH₂ or Cl₃SiCH₂CH₂SiCl₃.
<3>

   (Cl₃Si)₃CH.

Halosilanes are preferably selected from the group consisting of chlorosilane, bromosilane, iodosilane, dibromosilane, diiodosilane, tetrabromosilane, tetraiodosilane, pentachlorodisilane, pentabromodisilane, hexachlorodisilane,hexabromodisilane, and octachlorotrisilane.

Halosiloxanes or organo(halo)siloxanes allow formation of a film comprising silicon oxycarbonitride (SiOCN). The use of halosiloxanes or organo(halo)siloxanes allows a film comprising silicon oxycarbonitride (SiOCN) to be formed without any additional oxidation steps. The use of halosiloxanes or organo(halo)siloxanes also allows the oxygen content of the film comprising silicon oxycarbonitride (SiOCN) to be controlled.

Non-limiting examples of halosiloxanes include
Compounds represented by formula (5):

X₃Si-O(SiX₂)ₙSiX₃

[in formula (5), X is Cl, Br, or I; and n is an integer from 0 to 4], and preferably (Cl₃Si)₂O or Cl₃SiOSiCl₂OSiCl₃.

Non-limiting examples of organo(halo)siloxanes include
Compounds represented by formula (6):

R₃₋ₙXₙSi-O(SiX₂)ₘSiXₙR₃₋ₙ

[in formula (6), X is Cl, Br, or I; n is an integer from 0 to 4; R are independently H, a C1-C4 alkyl, a C2-C4 alkenyl, or a C2-C4 alkynyl] .

Oligohalosilanes are advantageous in forming thin films at lower temperatures as well as in increasing the thin film growth rate.

Non-limiting examples of oligohalosiloxanes include
Compounds represented by formula (7):

SiₙHₘX₍₂ₙ₊₂₎₋ₘ

[in formula (7), n is an integer from 2 to 6; m is an integer from 0 to 13; and X is Cl, Br, or I], and
preferably hexachlorodisilane(Si₂Cl₆₎, pentachlorodisilane(Si₂HCl₅₎, hexabromodisilane(Si₂Br₆₎, 1,2-dichlorodisilane(ClH₂Si-SiH₂Cl), 1,2-dibromodisilane(BrH₂Si-SiH₂Br), 1,2-diiododisilane(IH2Si-SiH2I) or octachlorotrisilane(Si₃Cl₈).

In this embodiment, the method for forming a silicon-containing film on a substrate may further comprise
(iii) providing a catalyst onto the substrate .

Providing a catalyst onto the substrate tends to result in improved thin film growth rate and improved film characteristics (such as homogeneity and conformality) of the thin film that is formed.

The catalyst may be provided at the same time as the silicon source compound and the carbon nitrogen source compound, or it may be provided at the same time as only the carbon nitrogen source compound. Alternatively, the catalyst may be provided separately from the silicon source compound and carbon nitrogen source compound.

The catalyst may be provided onto the substrate at any time point, provided that the effect of the present invention is not thereby compromised; for example, the catalyst can be provided on the substrate before, at the same time as, and/or after the other compounds and reagents are provided onto the substrate.

The catalyst may be provided one or more times onto the substrate. When a catalyst is provided more than once, the same or different catalyst may be provided.

Any catalyst can be used, provided that the the effect of the present invention is not thereby compromised, but organic amines are preferably used. Non-limiting examples of organic amines include heterocyclic amines (such as pyridine,2-methylpyridine,3-methylpyridine, 4-methylpyridine, dimethylpyridines, N- or C-alkylpiperidines, triethylenediamine, and 1,8-diazabicyclo[5.4.0]undec-7-ene), trialkylamines (such as triethylamine and dimethylamine), diamines (such as N,N'-dialkylethylenediamines), and alkylguanidines.

In this embodiment, the method for forming a silicon-containing film on a substrate may further comprise
(iv) providing a nitrogen-containing reagent onto the substrate.

Providing a nitrogen-containing reagent onto the substrate after the step comprising providing a carbon-nitrogen source of formula (1) in the method of this embodiment can result in additional advantages such as improved film growth rate and a lower temperature during film formation. The nitrogen content in the silicon-containing film can be increased. Halogen residues in the silicon-containing film can also be reduced.

The nitrogen-containing reagent may be
(a) one or more selected from the group consisting of ammonia, amines, hydrazine, alkylhydrazines, hexamethyldisilazane, and heptamethyldisilazane;
(b) one or more plasmas selected from the group consisting of ammonia, amines, hydrazine, alkylhydrazines, hexamethyldisilazane, and heptamethyldisilazane;
(c) nitrogen plasma; or
(d) a mixture of hydrogen plasma with (b) one or more plasmas selected from the group consisting of ammonia, amines, hydrazine, alkylhydrazines, hexamethyldisilazanes, and heptamethyldisilazanes or (c) nitrogen plasma.

The mixture (d) here may be, for example, a plasma obtained from a mixture of nitrogen gas and hydrogen gas.

The plasma may be, for example, a direct plasma or a remote plasma. The use of a nitrogen-containing plasma gas with properly adjusted characteristics provides an advantage to properly regulate the nitrogen content in the silicon-containing film. The use of a nitrogen-containing plasma can also reduce or curb the formation of C=N and C≡N bonds in the film, which affect the electrical properties and reactivity of silicon-containing films and thus allow the dielectric constant of the silicon-containing film to be effectively reduced and the etching resistance to be effectively enhanced.

In this embodiment, the method for forming a silicon-containing film on a substrate may further comprise
(v) providing a silane compound (excluding any that contain a silicon halide) onto the substrate .

Providing a silane compound (excluding any that contain a silicon halide) onto the substrate allows halogen contamination of the thin film to be reduced and allows the silicon content to be increased.

The silicon-containing reagent is typically
silane compounds represented by formula (8):

SiₙR₂ₙ₊₂

[in formula (8), R are independently H or methyl; and n is an integer from 1 to 8] .

In this embodiment, the method for forming a silicon-containing film on a substrate may further comprise
(vi) providing a boron-containing reagent onto the substrate.

Further providing a boron-containing reagent onto the substrate will allow boron-free films (such as silicon carbonitride (SiCN) films or silicon oxycarbonitride (SiOCN)) films) to be converted into boron-containing films (such as a silicoboron carbonitride (SiBCN) or a silicoboron oxycarbonitride (SiBOCN) films).

The boron-containing reagent is typically
a compound represented by formula (9):

BR₃

[in formula (9), R are independently Cl, Br, I, H, a C1-C9 alkyl, allyl, N(CH₃)₂, or N(C₂H₅)₂] .

In this embodiment, the at least one silicon source compound and a carbon-nitrogen source compound may be sequentially provided onto the substrate. The at least one silicon source compound and carbon-nitrogen source compound may also be provided simultaneously onto the substrate.

In this embodiment, the silicon-containing film may be formed on the substrate by chemical vapor deposition (CVD). CVD is a method in which a gas containing a silicon-containing film raw material is provided onto the surface of a substrate in a reactor to form a thin film on the substrate via a chemical reaction on the substrate surface or in the gas phase. CVD methods using heat, plasma, or light to induce a chemical reaction are referred to as thermal CVD, plasma-enhanced CVD (PECVD), and photo-assisted CVD, respectively. Atomic layer deposition (ALD) is a CVD method in which a thin film is formed on a substrate via repeated cycles (in which a gas containing two or more raw materials is introduced and exhausted), and the raw material molecules adsorbed onto the film-forming surface are reacted, resulting in deposition of the atomic layers, one layer at a time.

In the CVD method in this embodiment, the gas containing the reactive raw materials is preferably sequentially provided onto the substrate, and the raw materials that have been provided undergo a chemical reaction on the substrate surface or in the gas phase, forming a thin film on the substrate.

An example of the above chemical reaction is a reaction in which a silicon halide-containing silicon source compound, or a component in a thin film derived therefrom, and a carbon-nitrogen source compound, or a component in a thin film derived therefrom, are bonded using an amine as the catalyst. Typically, in this reaction, volatile by-products including halogens are released, and a silicon-containing film is formed on the substrate. The content and proportions of carbon atoms and nitrogen atoms in the silicon-containing film can be appropriately adjusted by adjusting the reagents that are used in the reaction and the reaction conditions. The release of the by-products may be accompanied by the release of nitrogen gas or nitrogen-containing gas, in which case the release of the by-products can lower the content and proportions of the nitrogen atoms in the silicon-containing film. In this reaction, the silicon source compound can also be converted into a more highly reactive molecular species via reaction with the carbon nitrogen source compound or a component in a thin film derived therefrom. The silicon source compound can be converted into a more highly reactive molecular species to improve the growth rate of the silicon-containing film.

In this embodiment, the compounds and reagents that are provided onto the substrate can be provided onto the substrate by providing a gas that contains the compounds and reagents onto the substrate.

The gas containing the compounds and reagents can be provided onto the substrate sequentially or simultaneously.

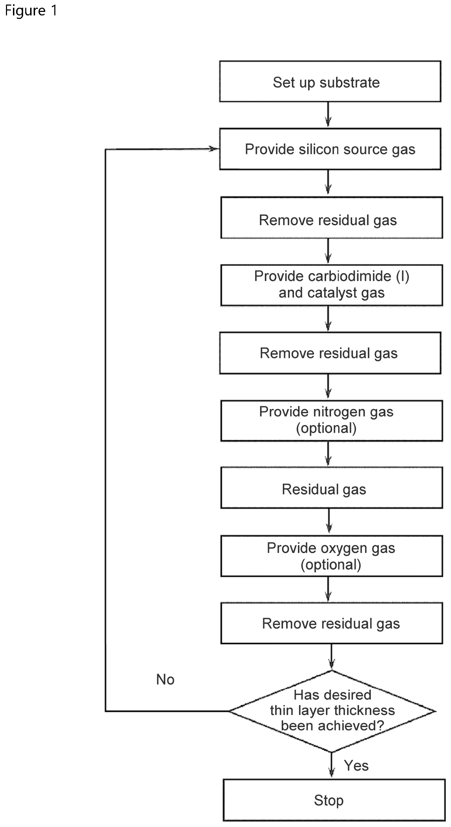

Figure 1 shows an exemplary CVD implementation scheme for this embodiment. In Figure 1, the "silicon source gas" is a gas that contains at least one silicon source compound noted above, the "carbodiimide (I)" is a carbon-nitrogen source compound represented by formula (1) above, the "catalyst gas" is a gas that contains the catalyst noted above, the nitrogen source gas is a gas that contains the nitrogen-containing reagent noted above, and the "oxidizing gas" is a gas that contains the oxidizing agent noted above.

In the scheme shown in Figure 1, the silicon source gas is provided onto a substrate that has been set up in a device, and the residual gas is then removed. The gas that contains the carbodiimide (I) and the optional catalyst gas are then provided, and the residual gas is then removed. The nitrogen source gas is then provided, as needed, and the residual gas is then removed. The oxidizing gas is then provided, as needed, and the residual gas is then removed. These operations constitute one cycle, where the cycle is repeated until the silicon-containing film reaches the intended thickness, resulting in the formation of a thin layer on the substrate.

The time points at which the catalyst gas, nitrogen source gas, and oxidizing gas are provided in Figure 1 are examples; the gases can actually be provided at any time point. For example, the nitrogen-containing gas can be supplied in small amounts at the same time as the gas that contains the carbodiimide (I). In such cases, the amount of carbodiimide (I) that is going to be reacted can be adjusted by setting the conditions to a lean carbodiimide (I) feed.

The CVD method in this embodiment may also involve treatment with a hydrogen, helium, or argon plasma, or a plasma mixture thereof. In such cases, the plasma may be provided onto the substrate after the gas containing a carbodiimide (I) or after the nitrogen source gas has been provided.

The hydrogen, helium, or argon plasma, or plasma mixture thereof, may be a direct plasma or a remote plasma, for example. Treatment with such a plasma can reduce or curb the formation of C=N and C≡N bonds that strongly affect the electrical properties and reactivity of silicon-containing films. Implementing such treatment, as needed, will thus allow the dielectric constant of the silicon-containing film to be effectively lowered (to a k of no more than 2, for example) and the etching resistance to be enhanced.

A CVD method based on the implementation scheme shown in Figure 1 can thus be used as the method for forming a silicon-containing film on a substrate, comprising: (i) providing at least one silicon source compound containing at least one silicon halide onto a substrate; and (ii) providing a carbon-nitrogen source compound represented by formula (1) onto the substrate.

However, the method is not limited to CVD methods based on the operating procedure shown in Figure 1.

For example, the method may include additional post-deposition in situ or ex situ treatments. Examples of additional treatments include: (a) post heat treatment (annealing) at 400 to 800°C and reduced pressure or in the presence of nitrogen, ammonia, or hydrogen; (b) post-plasma treatment at a low temperature (25 to 400°C) (treatment with nitrogen, ammonia, amine, or hydrazine plasma, hydrogen plasma, or argon or helium plasma); and/or (c) UV treatment at low temperature (25 to 400°C). These additional treatments can make it easier to form a silicon-containing film having the desired physical and chemical properties on a substrate.

Flowable CVD (FCVD) can also be used as the method. FCVD can ensure effective gap filling, and is thus suitable for use during shallow trench isolation (STI) and the formation of intermetal dielectric layers or passivation layers, for example.

The method can also be used to obtain compositions that are used in spin-on deposition.

In this embodiment, the reaction between the at least one silicon source compound containing at least one silicon halide and the carbon-nitrogen source compound represented by formula (1) can be carried out at 750°C or below or 450°C or below, or from 110°C to 750°C or from 550°C to 650°C, for example. If the silicon-containing film is deposited on the substrate via a CVD method, the CVD method can be performed at these temperatures.

Specifically, the method of this embodiment can be carried out at these temperatures to allow silicon-containing films having a variety of compositions and/or good physical and chemical properties to be formed on a substrate.

By-products of the reaction between the at least one silicon source compound containing at least one silicon halide and the carbon-nitrogen source compound represented by formula (1) are generally highly volatile, as noted above. The by-products can thus be easily removed from the reaction system. In conventional methods, on the other hand, salts (such as ammonium halides) are produced in the form of by-products of the reaction, as noted above, but the salts are generally characterized by low volatility and are not easy to remove from the reaction system.

In this embodiment, the substrate may be any substrate, provided that the effects of the present invention are not thereby compromised. The substrate may be in any form, such as in the form of a plate or in the form of powder, granules, or three-dimensional structures. The substrate may be of any material, and may be formed of a material such as silicon, glass, an oxide, ceramic, glass ceramic, or a combination thereof. The substrate may be for any application, and may be, for example, an electronic circuit board or a board other than an electronic circuit board. Electronic circuit boards may be optoelectronic circuit boards.

The substrate in this embodiment can be more strongly protected by a homogeneous silicon-containing film of high purity. There is also less substrate contamination by by-products in the film-forming step that may adhere to the substrate and adversely affect substrate function. The substrate can thus have better performance, such as in terms of reliability and durability.

### [Method for producing a substrate on which a thin film has been formed, and a product comprising a substrate on which a thin film has been formed]

One embodiment provides a method for producing a substrate on which a film has been formed, comprising the method for forming a silicon-containing film noted above. A method for producing a product comprising a substrate on which a film has been formed, which comprises said method, is also provided. The silicon-containing film, the method for forming the silicon-containing film, and the substrate are noted above. The substrate on which a film has been formed has a silicon-containing film disposed on at least one surface of the substrate. The product comprising a substrate on which a film has been formed comprises at least one substrate having a silicon-containing film disposed on at least one surface thereof.

The substrate on which a film has been formed that is produced in this embodiment can be used in any application, provided that the effect of the present invention is not thereby compromised. For example, the substrate can be used as a constituent component of products including electronic devices. Any product comprising a substrate on which a film has been formed that is produced in this embodiment can be selected, provided that the effect of the present invention is not thereby compromised. The product may be an electronic device. Non-limiting examples of electronic devices include computers and peripherals thereof, liquid crystal displays, organic EL displays, smart phones (cell phones), car navigation systems, game devices, televisions, digital cameras/digital video cameras, electronic dictionaries, calculators, printers, and electronic musical instruments.

### [Examples]

The present invention is illustrated by the following examples, but this example is not intended to limit the present invention. Commercially available reagents and equipment, for example, that are noted in the examples were used in accordance with the manufacturer's instructions or standard methods, unless otherwise specified.

### [Example 1]

### Formation of silicon-containing film by CVD (550°C)

N₂ gas containing Si₂Cl₆ was used as the gas containing a silicon source compound, N₂ gas containing (H₃C)₃Si-N=C=N-Si(CH₃)₃ (BTMSCDI) and pyridine was used as the gas containing a carbon-nitrogen source compound and a catalyst, ammonia was used as the nitrogen-containing reagent; these were provided in that order onto the substrate.

A silicon-containing film was formed on a silicon substrate via CVD at 550°C using a tubular horizontal flow type of hot-wall quartz reactor. The CVD conditions are shown in Tables 1 and 2.

**[Table 1]**

| Pressure (Torr) | Temperature (°C) | Flow rate (sccm) | | | | |
|---|---|---|---|---|---|---|
| | | Si₂Cl₆ /N₂ | BTMSCD IPy/N₂ | Processing N₂ gas | NH₃ | Purging N₂ gas |
| 10 | 550 | 2.2/35 | 6.7/6 7/55 | 40 | 100 | 80 |

**[Table 2]**

| Number of cycles | Si₂Cl₆ pulse (seconds) | N₂ purging (seconds) | BTMSCDI /Py pulse (seconds) | N₂ purging (seconds) | NH₃ pulse (seconds) | N₂ purging (seconds) |
|---|---|---|---|---|---|---|
| 150 | 15 | 20 | 30 | 15 | 10 | 10 |

The silicon-containing film thickness and growth rate (GPC) were analysed. The results are shown in Table 3. The silicon-containing film thickness was determined by ellipsometry.

**[Table 3]**

| Thin film thickness (nm) | GPC (Å/cycle) |
|---|---|
| 77 | 5.0 |

As shown in Table 3, the silicon-containing film of Example 1 was formed to the desired thickness at a favourable film growth rate.

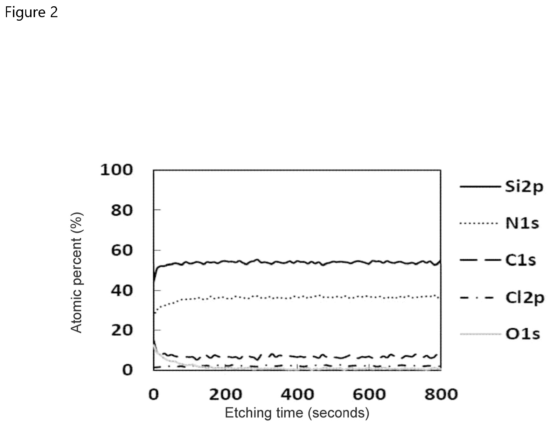

The constituent elements of the silicon-containing film of Example 1 were also analysed by X-ray photoelectron spectroscopy (XPS) (Figure 2). The composition of the silicon-containing film of Example 1 (etching time: 300 seconds) comprised 53.8% of Si2p, 36.2% of N1s, 7.5% of C1s, 2.0% of Cl2p, and 0.4% of O1s. Specifically, the silicon-containing film of Example 1 had a rich silicon content but a low oxygen content.

A non-limiting list of exemplary embodiments and combinations of exemplary embodiments of the present disclosure is disclosed below.
[1] A method for forming a silicon-containing film on a substrate, comprising:
   (i) providing at least one silicon source compound containing at least one silicon halide onto a substrate; and
   (ii) providing a carbon-nitrogen source compound represented by the following formula (1) onto the substrate:

      R¹₃E-N=C=N-ER¹₃

      [in formula (1), E are independently Si, Ge, or Sn, and R¹ are independently a C1-C6 alkyl, C2-C6 alkenyl, C4-C6 cycloalkyl, or C4-C6 cycloalkenyl] .
[2] The method according to [1], wherein E in formula (1) is Si.
[3] The method according to [1] or [2], wherein R¹ in formula (1) is CH₃.
[4] The method according to any of [1] through [3], wherein the at least one silicon source compound is selected from the group consisting of halosilanes, carbo(halo)silanes, halosiloxanes, organo(halo)siloxanes, and oligohalosilanes.
[5] The method according to any of [1] through [3], wherein the at least one silicon source compound is selected from the group consisting of chlorosilane, bromosilane, iodosilane, dibromosilane, diiodosilane, tetrabromosilane, tetraiodosilanes, pentachlorodisilane, pentabromodisilane, hexachlorodisilane,hexabromodisilane, and octachlorotrisilane.
[6] The method according to any of [1] through [5], further comprising
   (iii) providing a catalyst onto the substrate.
[7] The method according to [6], wherein the catalyst is an organic amine.
[8] A method comprising the method according to any of [1] through [7], further comprising
   (iv) providing a nitrogen-containing reagent onto the substrate.
[9] The method according to [8], wherein the nitrogen-containing reagent is
   (a) one or more selected from the group consisting of ammonia, amines, hydrazine, alkylhydrazines, hexamethyldisilazane, and heptamethyldisilazane;
   (b) one or more plasmas selected from the group consisting of ammonia, amines, hydrazine, alkylhydrazines, hexamethyldisilazane, and heptamethyldisilazane;
   (c) nitrogen plasma; or
   (d) a mixture of hydrogen plasma with (b) one or more plasmas selected from the group consisting of ammonia, amines, hydrazine, alkylhydrazines, hexamethyldisilazane, and heptamethyldisilazane or (c) nitrogen plasma .
[10] A method comprising the method according to any of [1] through [9], further comprising
   (v) providing a silane compound (excluding any that contain a silicon halide) onto the substrate.
[11] A method comprising the method according to any of [1] through [10], further comprising
   (vi) providing a boron-containing reagent onto the substrate.
[12] The method according to any of [1] through [11], wherein the at least one silicon source compound and carbon-nitrogen source compound are sequentially provided onto the substrate.
[13] The method according to any of [1] through [12], wherein the at least one silicon source compound and carbon-nitrogen source compound are provided simultaneously onto the substrate.
[14] The method according to any of [1] through [13], wherein the silicon-containing film is a silicon carbonitride (SiCN) film.
[15] The method according to any of [1] through [13], wherein the silicon-containing film is a silicon oxycarbonitride (SiOCN) film.
[16] The method according to any of [1] through [13], wherein the silicon-containing film is a silicoboron carbonitride (SiBCN) film.
[17] The method according to any of [1] through [13], wherein the silicon-containing film is a silicoboron oxycarbonitride (SiBOCN) film.
[18] The method according to any of [1] through [13], wherein the silicon-containing film is a silicon carbide (SiC) film.
[19] The method according to any of [1] through [18], wherein the substrate is an electronic circuit board.
[20] A method for producing substrate on which a film has been formed, comprising a method according to any of [1] through [19].
[21] A method for producing a product comprising a substrate on which a film has been formed, comprising the method according to [20].
[22] The method according to [21], wherein the product comprising a substrate on which a film has been formed is an electronic device.

## Claims

1. A method for forming a silicon-containing film on a substrate, comprising:
(i) providing at least one silicon source compound containing at least one silicon halide onto a substrate; and
(ii) providing a carbon-nitrogen source compound represented by the following formula (1) onto the substrate:
R¹₃E-N=C=N-ER¹₃
[in formula (1), E are independently Si, Ge, or Sn, and R¹ are independently a C1-C6 alkyl, C2-C6 alkenyl, C4-C6 cycloalkyl, or C4-C6 cycloalkenyl] .

2. The method according to Claim 1, wherein E in formula (1) is Si.

3. The method according to Claim 1, wherein R¹ in formula (1) is CH₃.

4. The method according to Claim 1, wherein the at least one silicon source compound is selected from the group consisting of halosilanes, carbo(halo)silanes, halosiloxanes, organo(halo)siloxanes, and oligohalosilanes.

5. The method according to Claim 1, wherein the at least one silicon source compound is selected from the group consisting of chlorosilane, bromosilane, iodosilane, dibromosilane, diiodosilane, tetrabromosilane, tetraiodosilane, pentachlorodisilane, pentabromodisilane, hexachlorodisilane,hexabromodisilane, and octachlorotrisilane.

6. The method according to Claim 1, further comprising (iii) providing a catalyst onto the substrate .

7. The method according to Claim 6, wherein the catalyst is an organic amine.

8. The method according to Claim 1, further comprising (iv) providing a nitrogen-containing reagent onto the substrate .

9. The method according to Claim 8, wherein the nitrogen-containing reagent is
(a) one or more selected from the group consisting of ammonia, amines, hydrazine, alkylhydrazines, hexamethyldisilazane, and heptamethyldisilazane;
(b) one or more plasmas selected from the group consisting of ammonia, amines, hydrazine, alkylhydrazines, hexamethyldisilazane, and heptamethyldisilazane;
(c) nitrogen plasma; or
(d) a mixture of hydrogen plasma with (b) one or more plasmas selected from the group consisting of ammonia, amines, hydrazine, alkylhydrazines, hexamethyldisilazane, and heptamethyldisilazane or (c) nitrogen plasma .

10. The method according to Claim 1, further comprising (v) providing a silane compound(excluding any that contain a silicon halide) onto the substrate .

11. The method according to Claim 1, further comprising (vi) providing a boron-containing reagent onto the substrate .

12. The method according to Claim 1, wherein the at least one silicon source compound and carbon-nitrogen source compound are sequentially provided onto the substrate.

13. The method according to Claim 1, wherein the at least one silicon source compound and carbon-nitrogen source compound are provided simultaneously onto the substrate.

14. The method according to Claim 1, wherein the silicon-containing film is a silicon carbonitride (SiCN) film.

15. The method according to Claim 1, wherein the silicon-containing film is a silicon oxycarbonitride (SiOCN) film.

16. The method according to Claim 1, wherein the silicon-containing film is a silicoboron carbonitride (SiBCN) film.

17. The method according to Claim 1, wherein the silicon-containing film is a silicoboron oxycarbonitride (SiBOCN) film.

18. The method according to Claim 1, wherein the silicon-containing film is a silicon carbide (SiC) film.

19. The method according to Claim 1, wherein the substrate is an electronic circuit board.

20. A method for producing a substrate on which a film has been formed, comprising a method according to any of claims 1 through 19.

21. A method for producing a product comprising a substrate on which a film has been formed, comprising the method according to Claim 20.

22. The method according to Claim 21, wherein the product comprising a substrate on which a film has been formed is an electronic device.

## Amended claims

### Amended claims in accordance with Rule 137(2) EPC.

1. A method for forming a silicon-containing film on a substrate by chemical vapor deposition or atomic layer deposition, comprising:
(i) providing at least one silicon source compound containing at least one silicon halide onto a substrate; and
(ii) providing a carbon-nitrogen source compound represented by the following formula (1) onto the substrate:
R¹₃E-N=C=N-ER¹₃
[in formula (1), E are independently Si, Ge, or Sn, and R¹ are independently a C1-C6 alkyl, C2-C6 alkenyl, C4-C6 cycloalkyl, or C4-C6 cycloalkenyl] .

2. The method according to Claim 1, wherein E in formula (1) is Si.

3. The method according to Claim 1, wherein R¹ in formula (1) is CH₃.

4. The method according to Claim 1, wherein the at least one silicon source compound is selected from the group consisting of halosilanes, carbo(halo)silanes, halosiloxanes, organo(halo)siloxanes, and oligohalosilanes.

5. The method according to Claim 1, wherein the at least one silicon source compound is selected from the group consisting of chlorosilane, bromosilane, iodosilane, dibromosilane, diiodosilane, tetrabromosilane, tetraiodosilane, pentachlorodisilane, pentabromodisilane, hexachlorodisilane,hexabromodisilane, and octachlorotrisilane.

6. The method according to Claim 1, further comprising (iii) providing a catalyst onto the substrate .

7. The method according to Claim 6, wherein the catalyst is an organic amine.

8. The method according to Claim 1, further comprising (iv) providing a nitrogen-containing reagent onto the substrate .

9. The method according to Claim 8, wherein the nitrogen-containing reagent is
(a) one or more selected from the group consisting of ammonia, amines, hydrazine, alkylhydrazines, hexamethyldisilazane, and heptamethyldisilazane;
(b) one or more plasmas selected from the group consisting of ammonia, amines, hydrazine, alkylhydrazines, hexamethyldisilazane, and heptamethyldisilazane;
(c) nitrogen plasma; or
(d) a mixture of hydrogen plasma with (b) one or more plasmas selected from the group consisting of ammonia, amines, hydrazine, alkylhydrazines, hexamethyldisilazane, and heptamethyldisilazane or (c) nitrogen plasma .

10. The method according to Claim 1, further comprising (v) providing a silane compound(excluding any that contain a silicon halide) onto the substrate .

11. The method according to Claim 1, further comprising (vi) providing a boron-containing reagent onto the substrate .

12. The method according to Claim 1, wherein the at least one silicon source compound and carbon-nitrogen source compound are sequentially provided onto the substrate.

13. The method according to Claim 1, wherein the at least one silicon source compound and carbon-nitrogen source compound are provided simultaneously onto the substrate.

14. The method according to Claim 1, wherein the silicon-containing film is a silicon carbonitride (SiCN) film.

15. The method according to Claim 1, wherein the silicon-containing film is a silicon oxycarbonitride (SiOCN) film.

16. The method according to Claim 1, wherein the silicon-containing film is a silicoboron carbonitride (SiBCN) film.

17. The method according to Claim 1, wherein the silicon-containing film is a silicoboron oxycarbonitride (SiBOCN) film.

18. The method according to Claim 1, wherein the silicon-containing film is a silicon carbide (SiC) film.

19. The method according to Claim 1, wherein the substrate is an electronic circuit board.

20. A method for producing a substrate on which a film has been formed, comprising a method according to any of claims 1 through 19.

21. A method for producing a product comprising a substrate on which a film has been formed, comprising the method according to Claim 20.

22. The method according to Claim 21, wherein the product comprising a substrate on which a film has been formed is an electronic device.
